# EUROPEAN PATENT APPLICATION

(11) **EP 4 138 129 A1**
(43) Date of publication of application: **22.02.2023**
(21) Application number: 20933415.0
(22) Date of filing: 30.04.2020
(51) Int. Cl.: H01L 27/02, H01L 29/78

(54) **INTEGRATED CIRCUIT**

(71) Applicant: Huawei Technologies Co., Ltd., Shenzhen, Guangdong 518129 (CN)
(72) Inventor: QIN, Xi, Shenzhen, Guangdong 518129 (CN); GU, Xun, Shenzhen, Guangdong 518129 (CN); TIAN, Yu, Shenzhen, Guangdong 518129 (CN)
(74) Representative: Maiwald GmbH
(86) International application number: PCT/CN2020/088295
(87) International publication number: WO 2021/217582

(57) **Abstract**

This application provides an integrated circuit, including a first MOS transistor. A first effective gate (G1) and a second effective gate (G2) are disposed in the first MOS transistor, and a first redundant gate (DG1) is disposed between the first effective gate (G1) and the second effective gate (G2). The first effective gate (G1), the second effective gate (G2), and the first redundant gate (DG1) cover a plurality of fins arranged in parallel. The first effective gate (G1) and the second effective gate (G1) are connected to a gate terminal of the first MOS transistor. Fins on both sides of the first effective gate (G1) and fins on both sides of the second effective gate (G1) are respectively connected to a source terminal (S1) and a drain terminal (D1) of the first MOS transistor. The first redundant gate (DG1) is connected to a redundant potential or suspended. A current density of a unit MOS transistor may be reduced by using a structure of the redundant gate (DG1/DG2) disposed between the two effective gates, thereby improving heat dissipation performance.

## Description

### TECHNICAL FIELD

This application relates to an integrated circuit, and in particular, to an integrated circuit that improves heat dissipation performance of a fin field effect transistor (FinFET)-based process.

### BACKGROUND

An integrated circuit is also referred to as a chip, and is core driving force of modern scientific and technological progress. With evolution of the integrated circuit from a planar field effect transistor (Planar FET) process to a FinFET process, a transistor as a basic unit of the integrated circuit changes from an original planar structure to a three-dimensional (3D: 3 dimensional) structure, bringing a smaller transistor size and a smaller integrated circuit area. As an integration degree increases, a higher heat density is brought. Therefore, a heat dissipation problem that plagues the chip field becomes more prominent in the FinFET process.

### SUMMARY

This application provides and relates to an integrated circuit based on a fin field effect transistor (FinFET) process structure, to improve heat dissipation performance of a chip apparatus.

According to a first aspect, this application provides an integrated circuit, including a first metal oxide semiconductor field effect transistor (MOS transistor). A first effective gate and a second effective gate are disposed in the first MOS transistor, and a first redundant gate is disposed between the first effective gate and the second effective gate. The first effective gate, the second effective gate, and the first redundant gate cover a plurality of fins arranged in parallel. The first effective gate and the second effective gate are connected to a gate terminal of the first MOS transistor. Fins on both sides of the first effective gate and fins on both sides of the second effective gate are respectively connected to a source terminal and a drain terminal of the first MOS transistor. The first redundant gate is connected to a redundant potential or suspended.

According to the foregoing technical solution, a current density of a unit MOS transistor may be reduced by using a structure of the redundant gate disposed between the two effective gates, thereby improving heat dissipation performance.

With reference to any one of the foregoing possible implementations, in a possible implementation, a second redundant gate is further included, and the second redundant gate is located between the first gate and the second gate.

The second redundant gate is connected to the redundant potential or suspended.

According to the foregoing technical solution, on a basis of the first redundant gate, the second redundant gate is further disposed between the two effective gates, so that a current density of a unit MOS transistor may be further reduced, and heat dissipation performance may be further improved.

With reference to any one of the foregoing possible implementations, in a possible implementation, the first MOS transistor is an NMOS transistor, and the redundant potential is coupled to a ground terminal of the integrated circuit.

According to the foregoing technical solution, the redundant gate of the NMOS transistor based on the FinFET structure exports some heat generated by the MOS transistor to an outside of the integrated circuit by using a connection wire to the ground terminal, so that heat dissipation performance may be further improved.

With reference to any one of the foregoing possible implementations, in a possible implementation, a first guard ring is further included, and the first guard ring is disposed on one or more sides of the NMOS transistor. The first guard ring is a P-type guard ring.

According to the foregoing technical solution, due to use of the guard ring, a substrate of the NMOS transistor based on the FinFET structure may be connected to the ground terminal of the integrated circuit by using the P-type guard ring, and the P-type guard ring may be disposed on one or more sides based on an actual chip area layout. In this way, based on any one of the foregoing possible redundant gate structures, heat dissipation performance of the NMOS transistor based on the structure of the P-type guard ring may be further improved.

With reference to any one of the foregoing possible implementations, in a possible implementation, the first MOS transistor is a PMOS transistor, and the redundant potential terminal is coupled to a power supply terminal of the integrated circuit.

According to the foregoing technical solution, the redundant gate of the PMOS transistor based on the FinFET structure exports some heat generated by the MOS transistor to an outside of the integrated circuit by using a connection wire to the power supply terminal of the integrated circuit, so that heat dissipation performance may be further improved.

With reference to any one of the foregoing possible implementations, in a possible implementation, a first guard ring is further included, and the first guard ring is disposed on one or more sides of the PMOS transistor. The first guard ring is an N-type guard ring.

According to the foregoing technical solution, due to use of the guard ring, a substrate of the PMOS transistor based on the FinFET structure may be connected to the power supply terminal of the integrated circuit by using the N-type guard ring, and the N-type guard ring may be disposed on one or more sides based on an actual chip area layout. In this way, based on any one of the foregoing possible redundant gate structures, heat dissipation performance of the PMOS transistor based on the structure of the N-type guard ring may be further improved.

With reference to any one of the foregoing possible implementations, in a possible implementation, one or more openings are disposed on the first guard ring.

According to the foregoing technical solution, use of the guard ring is more flexible, and open or closed disposing can achieve effect of improving heat dissipation performance of the first MOS transistor.

With reference to any one of the foregoing possible implementations, in a possible implementation, the first MOS transistor is disposed in a hotspot area of the integrated circuit.

According to the foregoing technical solution, a transistor located in the hotspot area may also use the FinFET transistor structure with the redundant gate, thereby helping further improve heat efficiency of the hotspot (hotspot) area, and further improving heat dissipation performance of the integrated circuit.

According to a second aspect, this application further provides a power amplifier. A first amplifier transistor is disposed in the power amplifier, and the first amplifier transistor is configured to amplify a signal received by the power amplifier.

The first amplifier includes the first MOS transistor according to any one of the first aspect or the possible implementations of the first aspect.

According to the foregoing technical solution, the amplifier transistor is a transistor carrying high heat power consumption in the PA. Therefore, the FinFET transistor using the redundant gate in the foregoing embodiment may be first used for the amplifier transistor, to improve heat dissipation performance of the PA. Because the transistor that mainly causes heat dissipation is identified, an excessively large area increase is not caused to the PA.

According to a third aspect, this application further provides a power module. A power transistor is disposed in the power module, and the power transistor includes the first MOS transistor according to any one of the first aspect or the possible implementations of the first aspect.

According to the foregoing technical solution, the power transistor is a transistor carrying high heat power consumption in the power module. Therefore, the FinFET transistor using the redundant gate in the foregoing embodiment may be first used for the power transistor, to improve heat dissipation performance of the power module. Because the transistor that mainly causes heat dissipation is identified, a sacrifice of an excessively large area is not caused to the power module.

According to a fourth aspect, this application further provides a terminal, including the integrated circuit according to any one of the first aspect or the possible implementations of the first aspect, the power amplifier according to the second aspect, or the power module according to the third aspect.

### BRIEF DESCRIPTION OF DRAWINGS

FIG. 1 is a schematic diagram of a structure of a FinFET according to an embodiment of this application;
FIG. 2 is a schematic diagram of a structure of a FinFET with a redundant gate according to an embodiment of this application;
FIG. 3 is a schematic diagram of a structure of another FinFET with a redundant gate according to an embodiment of this application;
FIG. 4 is a schematic diagram of a structure of another FinFET with a redundant gate according to an embodiment of this application;
FIG. 5 is a schematic diagram of a hot area of a chip according to an embodiment of this application;
FIG. 6 is a schematic diagram of a power amplifier circuit of a FinFET using a redundant gate according to an embodiment of this application;
FIG. 7 is a schematic diagram of a plurality of single-ended power amplifier circuits of a FinFET using a redundant gate according to an embodiment of this application;
FIG. 8(a) to FIG. 8(d) are a schematic diagram of a plurality of differential dual-ended power amplifier circuits of a FinFET using a redundant gate according to an embodiment of this application; and
FIG. 9 is a schematic diagram of a power module of a FinFET using a redundant gate according to an embodiment of this application.

It should be understood that sizes and shapes of block diagrams in the foregoing schematic diagrams are for reference only, and should not constitute exclusive interpretation of the embodiments of this application. A relative location and an inclusion relationship between block diagrams presented in the schematic diagrams of structures merely schematically indicate a structural association between block diagrams, but do not limit a physical connection manner in the embodiments of this application.

### DESCRIPTION OF EMBODIMENTS

With reference to accompanying drawings and embodiments, the following further describes technical solutions provided in this application. It should be understood that a system structure and a service scenario provided in the embodiments of this application are mainly intended to explain some possible implementations of the technical solutions of this application, and should not be construed as a unique limitation on the technical solutions of this application. A person of ordinary skill in the art may know that, as a system evolves and an updated service scenario emerges, the technical solutions provided in this application are still applicable to a same or similar technical problem.

It should be understood that the technical solutions provided in the embodiments of this application include a sounding reference signal sending method and a related apparatus. Problem-resolving principles of the technical solutions are the same or similar. Some repetitions may not be described in the following description of specific embodiments, but it should be considered that these specific embodiments have been referenced to each other and may be combined with each other.

A metal oxide semiconductor field effect transistor (CMOS) integrated circuit gradually evolves from a planar FET process to a FinFET process from a 16 nm process node, and a transistor as a basic component of the integrated circuit changes from an original planar structure to a 3D structure. A planar source (Source) and a planar drain (Drain) are disposed on a silicon substrate of a planar FET, and then a gate (Gate) is covered on the planar source and the planar drain. Compared with a transistor of the planar FET, a source and a drain of a FinFET are disposed in a shape of a fin (Fin), a gate wraps the fin to form a 3D structure, and fins on both sides of the gate are respectively the source and the drain of the FinFET.

In the planar FET, under a condition of an advanced process node, the gate cannot provide enough potential control on a channel area formed by the source and the drain. Therefore, ideal turn-off between the source and the drain cannot be achieved. This is because there is a leakage current between a CMOS source and a CMOS drain under the condition of the advanced process node in a turn-off state of the planar FET. Moreover, with further evolution of the transistor process, a size between a source and a drain becomes increasingly smaller, and such a leakage current becomes increasingly larger, leading to increasingly more significant leakage effect in the turn-off state. Consequently, performance of the planar FET becomes increasingly worse.

Compared with the planar FET, the drain and the source of the FinFET are fabricated in a shape of a fin perpendicular to a silicon substrate, and the gate wraps and controls the fin from three sides of the fin. Due to a larger contact area, compared with the planar FET, the gate of the FinFET can better implement turn-off control on a source-drain channel in an advanced process. In the turn-off state, a leakage current between the source and the drain of the FinFET is very small. Therefore, compared with the planar FET, the FinFET can achieve a better on/off feature and better performance in the advanced process, and therefore is preferred for the advanced process node.

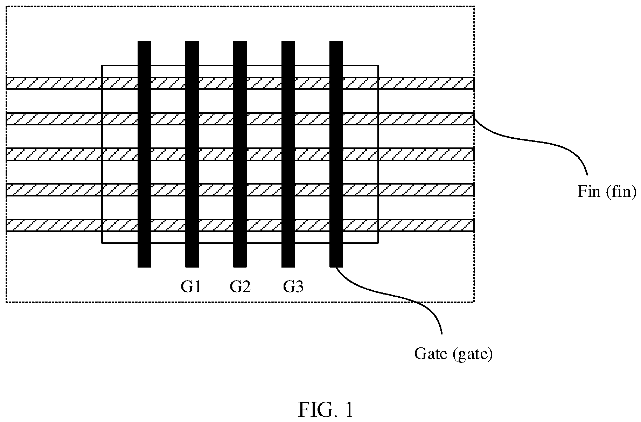

FIG. 1 is a schematic diagram of a structure of a FinFET according to an embodiment of this application. When a size of a single MOS transistor based on a FinFET structure is relatively large, a structure in which a plurality of parallel gates cover a plurality of parallel fins is generally used. As shown in FIG. 1, a plurality of gates (gate) cover a plurality of parallel fins (Fin). The structure can fully use a space size of the FinFET. However, when the structure is used, adjacent gates are affected by a plurality of parallel fins, leading to a self-heating effect. Specifically, as shown in the figure, adjacent gates G1, G2, and G3 are used as an example. When the gates are conducted, a current is generated on parallel fins between the three adjacent gates, causing the MOS transistor to heat up. Therefore, a self-heating effect is generated. In addition, as a quantity of gates increases, a heat dissipation environment becomes worse, a temperature of the gates of the MOS transistor increases more relative to a silicon substrate, and the self-heating effect becomes more serious. A high temperature deteriorates a feature of a circuit. In addition, working in a high temperature mode for a long time greatly shortens a lifespan of a component and affects reliability of a chip. Therefore, there is an urgent need for a method to improve heating of the FinFET.

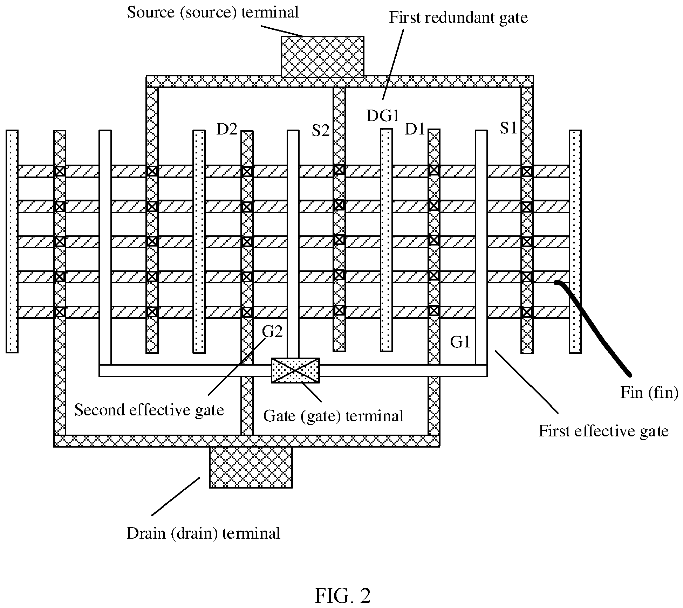

FIG. 2 is a schematic diagram of a structure of a FinFET with a redundant gate according to an embodiment of this application. As shown in FIG. 2, in the MOS transistor, there are a plurality of fins arranged in parallel, and effective gate and a redundant gate are disposed on the fins. As shown in the figure, a plurality of effective gates and fins located on both sides of the plurality of effective gates together constitute a gate terminal, a drain terminal, and a source terminal of the MOS transistor. When a conduction potential is applied to effective finger, a source and a drain of fins located on both sides of the effective finger can be conducted, and a conduction current flows through the fins in a source-drain direction. Although the redundant gate covers a plurality of parallel fins, fins located on both sides of a redundant finger cannot be conducted and are in a cut-off state. Optionally, the redundant gate on the redundant finger may be suspended and not connected to any potential.

Using FIG. 2 as an example, a first redundant gate (DG1) is disposed between a first effective gate (G1) and a second effective gate (G2) that cover a plurality of parallel fins. G1 and G2 are connected to the gate terminal of the MOS transistor, and DG1 is suspended. A plurality of fins on both sides of G1 are connected to a drain D1 and a source S1. A plurality of fins on both sides of G2 are connected to D2 and S2. S1 and S2 are jointly connected to the source terminal of the MOS transistor, and D1 and D2 are jointly connected to the drain terminal of the MOS transistor. When the FinFET transistor is conducted, a conduction current flows through a fin between S1 and D1 and a fin between S2 and D2. However, because there is DG1 between G1 and G2, no conduction current flows through a plurality of fins between S2 and D1. Because a current flowing through a unit area is reduced, the FinFET structure based on a staggered layout of the effective gate and the redundant gate can improve heat dissipation performance of the MOS transistor.

Further, based on the foregoing FinFET structure, in addition to the first redundant gate, a second redundant gate or more redundant gates may be further included between the first effective gate and the second effective gate. In this way, a current density of a unit MOS transistor may be further reduced, and the heat dissipation performance may be further improved.

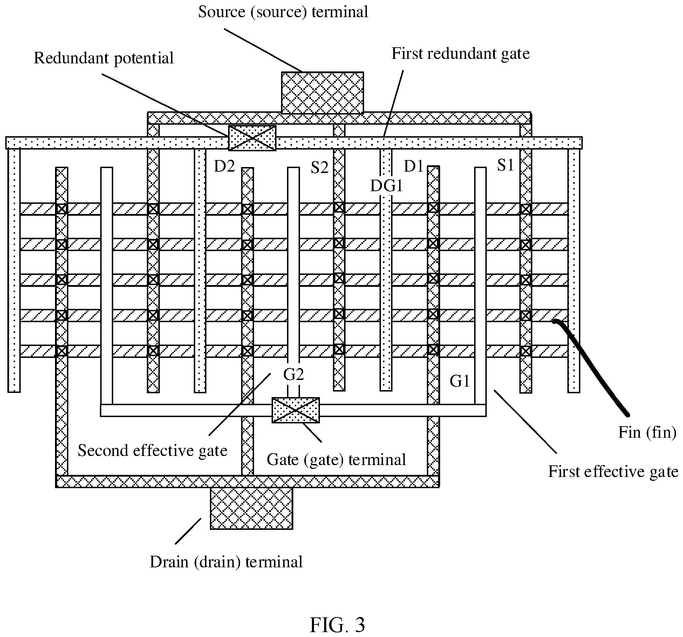

FIG. 3 is a schematic diagram of a structure of another FinFET with a redundant gate according to an embodiment of this application. Based on the foregoing embodiment, the redundant gate may be coupled to a redundant potential by using a connection wire. The redundant potential is used to enable the redundant gate to be turned off, so that fins on both sides of the redundant gate cannot be conducted.

Specifically, when the FinFET is an NMOS, the redundant potential is connected to a ground terminal (GND) of an integrated circuit in which the MOS transistor is located. When the FinFET is a PMOS, the redundant potential is connected to a power supply terminal (VDD) of the integrated circuit in which the MOS transistor is located. The integrated circuit is coupled to a power supply potential and a ground potential outside the integrated circuit by using the ground terminal and the power supply terminal.

Compared with the suspended redundant gate, the redundant gate connected to the redundant potential can prevent the redundant gate from being mistakenly turned on due to uncertainty caused by suspension. In addition, because the redundant gate is connected to the GND or the VDD of the integrated circuit, the redundant gate may export some heat generated by the MOS transistor to an outside of the integrated circuit by using connection wires to the GND and the VDD, thereby further improving heat dissipation performance.

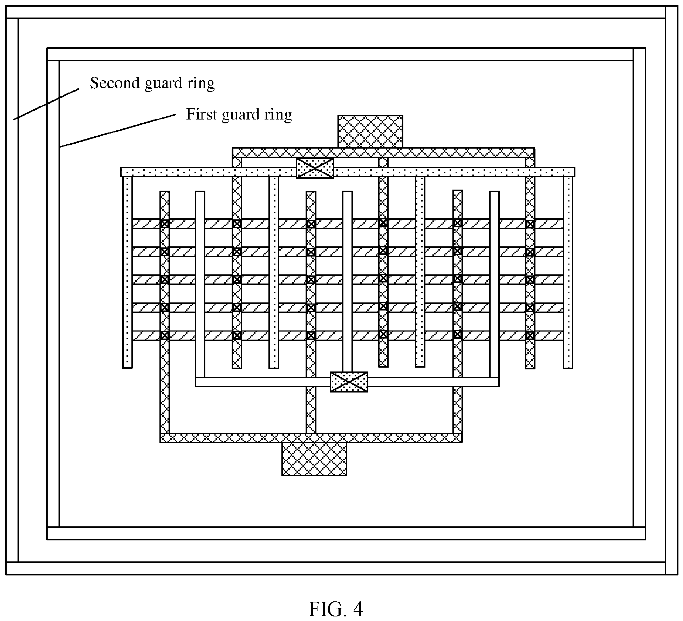

FIG. 4 is a schematic diagram of a structure of another FinFET with a redundant gate according to an embodiment of this application. Based on the foregoing embodiment, a guard ring (guard ring) may be disposed on one or more sides of the MOS transistor. The guard ring may be closed, or may have a plurality of gaps. One or more guard rings may be disposed around the MOS transistor.

Specifically, as shown in FIG. 4, a first guard ring is disposed around the MOS transistor. The first guard ring may be closed, or may have a plurality of openings. The first guard ring may alternatively be disposed only on one side of the MOS transistor.

Further, based on the first guard ring, a second guard ring may be further disposed on the integrated circuit, and the first guard ring is disposed between the second guard ring and the FinFET transistor. Similar to the first guard ring, the second guard ring may be disposed around the MOS transistor, or the second guard ring may be disposed only on one side of the first guard ring. The second guard ring may be closed, or may have a plurality of openings.

A specific type of the guard ring varies with the MOS transistor. Specifically, when the MOS transistor is a PMOS transistor, the first guard ring is an N-type guard ring, and the second guard ring is a P-type guard ring. When the MOS transistor is a deep N-well NMOS transistor, the first guard ring is a P-type guard ring, the second guard ring is an N-type guard ring, and a third guard ring that is a P-type guard ring may be further disposed outside the second guard ring.

Due to use of the guard ring, a substrate of the FinFET may be connected to the ground terminal or the VDD terminal of the integrated circuit by using the guard ring, and the guard ring may be disposed on one or more sides in an open or closed manner based on an actual chip area layout. In this way, based on the foregoing redundant gate, heat dissipation performance of the MOS transistor based on the structure of the guard ring may be further improved.

It should be noted that, although better heat dissipation performance may be achieved based on the MOS transistor with the redundant gate in this embodiment of this application, additional area costs are paid for the structure of the redundant gate. Therefore, identifying a circuit module with a high heat dissipation requirement and specifically identifying a specific transistor in the circuit module, and then using the structure based on the redundant gate is also a problem to be considered in a chip design.

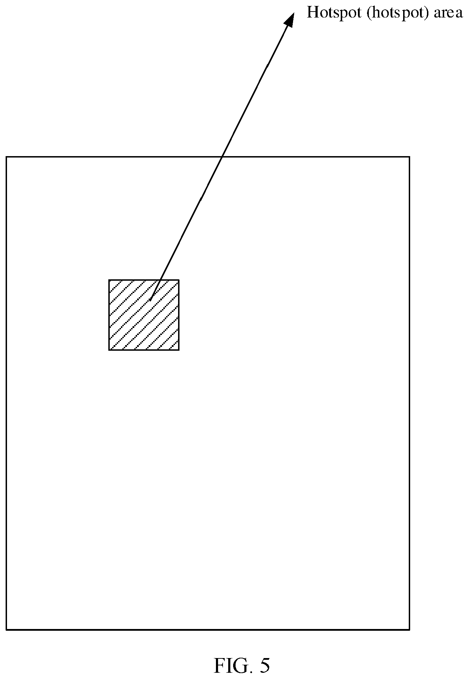

FIG. 5 is a schematic diagram of a hot area of a chip according to an embodiment of this application. As shown in FIG. 5, when the chip normally works, heat generated in some local areas is greater than heat generated in other areas, and the areas are referred to as hotspot (hotspot) areas. A transistor located in the hotspot area may also use the FinFET transistor structure with the redundant gate described in the foregoing embodiment, thereby helping reduce heating of the hotspot. The hotspot may be a specific analog function module, for example, a power amplifier or a power supply module; or may be a digital operation module, for example, a CPU, a GPU, or a storage module.

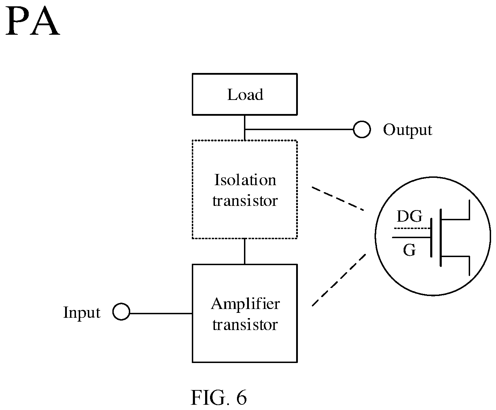

FIG. 6 is a schematic diagram of a power amplifier circuit of a FinFET using a redundant gate according to an embodiment of this application. A power amplifier (PA: power amplifier) circuit is an important functional circuit in a wireless communications system, and is configured to amplify power of a transmit signal. The PA is a circuit that has a high requirement on chip heat dissipation. A system of the PA is complex, and an overall layout area is relatively large. Therefore, using the structure in the foregoing embodiment for all transistors of the PA may cause a problem of an excessively large area. A core transistor in the PA is identified, and the FinFET structure with the redundant gate described in the foregoing embodiment is used for the core transistor, so that heat dissipation performance may be improved, and area optimization may also be achieved.

Specifically, as shown in FIG. 6, the PA includes an amplifier transistor and a load. One end of the amplifier transistor is coupled to an input (Input) end of the PA, and is configured to receive and amplify an input signal. The other end of the amplifier transistor is coupled to an output (Output) end of the PA. The load coupled to the output end is configured to provide impedance matching for an output signal. The amplifier transistor is a transistor carrying high heat power consumption in the PA. Therefore, the FinFET transistor with the redundant gate in the foregoing embodiment may be used for the amplifier transistor, to improve heat dissipation performance of the PA. Because the transistor that mainly causes heat dissipation is identified, a sacrifice of an excessively large area is not caused to the PA.

Further, the PA may further include an isolation transistor, configured to implement better isolation between the input (Input) end and the output (Output) end. Because a large current also flows through the isolation transistor, the structure with the redundant gate may also be used for the isolation transistor on a basis of the amplifier transistor. Therefore, the heat dissipation performance of the PA is further improved.

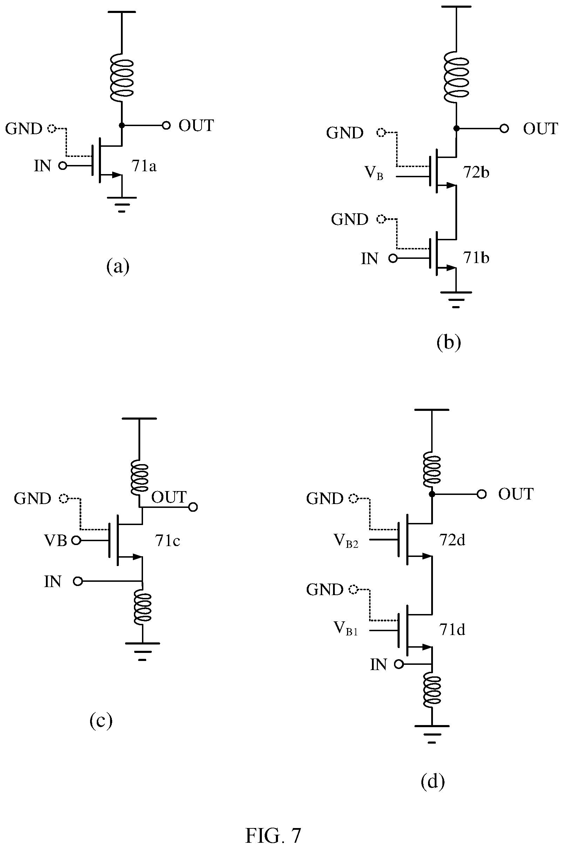

FIG. 7 is a schematic diagram of a plurality of single-ended power amplifier circuits of a FinFET using a redundant gate according to an embodiment of this application. Specifically, FIG. 7(a) is a PA in a common-source amplifier architecture. An amplifier transistor 71a is an NMOS transistor, and effective gate of the NMOS transistor is coupled to a signal input end (IN) of the PA, and is configured to receive a to-be-amplified signal. A redundant gate of the NMOS transistor is coupled to a ground terminal (GND) of an integrated circuit in which the NMOS transistor is located. A source of the NMOS transistor is configured to be coupled to the ground terminal of the PA, as shown in the figure. Optionally, a matching component or another MOS transistor may be further disposed between the NMOS transistor and the ground terminal. A drain of the NMOS transistor is configured to be coupled to an output end (OUT), and output an amplified signal, and the output end is coupled to a load inductor for matching.

Further, an isolation transistor may be further included between an amplifier transistor and a load of a common-source amplifier. As shown in FIG. 7(b), an amplifier transistor 71b and an isolation transistor 72b constitute a cascode (cascade) amplifier structure. The amplifier 71b is an NMOS transistor, and 72b is also an NMOS transistor. Effective gate of 71b is configured to receive an input signal (IN) of the PA, effective gate of 72b is configured to receive a bias voltage (VB: voltage bias), and redundant gates of 71b and 72b are respectively coupled to ground terminals (GND).

In addition to the common-source amplifier architecture, the power amplifier circuit may also be based on a common-gate architecture. As shown in FIG. 7(c), an amplifier transistor 71c is an NMOS transistor, effective gate of 71c is configured to receive a bias voltage (VB), and a redundant gate of 71c is configured to be grounded (GND). A source of 71c is configured to be coupled to an input end (IN), and receive a to-be-amplified signal. A drain of 71c is configured to be coupled to a load end (OUT), and output an amplified signal. An inductor is coupled between the source of 71c and the ground, and the drain of 71c is coupled to a power supply terminal by using an inductor.

Further, the common-gate amplifier may further include an isolation transistor. As shown in FIG. 7(d), an NMOS transistor 72d is further included between an amplifier transistor 71d and a load end, effective gate of 72d is configured to receive a proper bias voltage (VB2: voltage bias), and a redundant gate of 72d is also coupled to a ground terminal. Optionally, redundant gates of all or some of the amplifier transistors and the isolation transistors shown in FIG. 7 may alternatively be suspended.

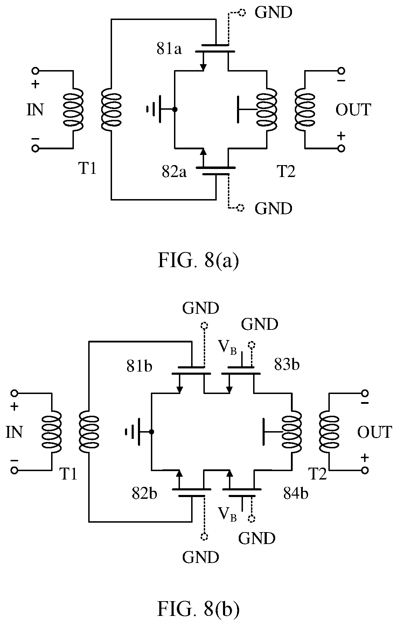

FIG. 8(a) to FIG. 8(d) are a schematic diagram of a plurality of differential dual-ended power amplifier circuits of a FinFET using a redundant gate according to an embodiment of this application. On a single-ended basis of FIG. 7(a), as shown in FIG. 8(a), a differential signal received by an input end (IN) of a PA is coupled to effective gates of two amplifier transistors 81a and 82a by using an input transformer coil T1. In addition, redundant gates of the two amplifier transistors are coupled to ground terminals. Differential signals output by drains of the two amplifier transistors are coupled to an output end (OUT) of the PA by using an output transformer coil T2. Sources of the two amplifier transistors may be grounded directly or by using matching components.

Similarly, an isolation transistor may be further included between a differential amplifier transistor and an output signal, as shown in FIG. 8(b). On a basis of FIG. 8(a), differential amplifier transistors 81b and 82b in FIG. 8(b) are coupled to the output transformer coil T2 by using two isolation transistors 83b and 84b respectively.

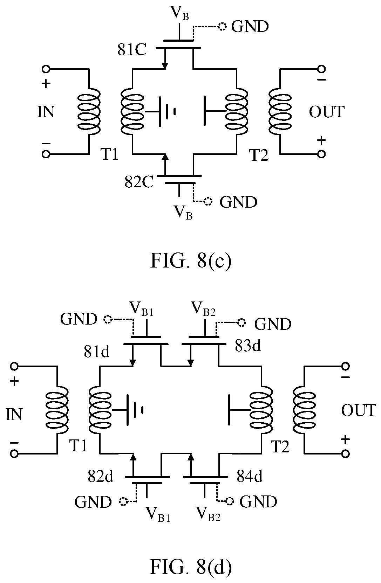

In addition to the differential common-source amplifier architecture, the differential dual-ended power amplifier may also use a differential common-gate amplifier architecture, as shown in FIG. 8(c) and FIG. 8(d). On a basis of the single-ended architecture shown in FIG. 7(a) and FIG. 7(b), a differential signal received by a differential input end (IN) and coupled to the input transformer T1 is coupled to sources of two amplifiers 81c and 82c. Drains of the two amplifier transistors are configured to output differential signals to an output end to which the output transformer T2 is coupled. Effective gates of the amplifier transistors 81c and 82c are configured to be coupled to a bias voltage (VB1), and establish a direct current operating point. Redundant gates of the two amplifier transistors are respectively coupled to ground terminals.

Further, on a basis of FIG. 8(c), as shown in FIG. 8(d), isolation transistors 83d and 84d may be further coupled between two amplifier transistors 81d and 82d and the output. Connection manners of effective gates and redundant gates of the isolation transistors are the same as the connection manners of the effective gate and the redundant gate of the isolation transistor shown in FIG. 7(d).

Optionally, redundant gates of all or some of the amplifier transistors and the isolation transistors shown in FIG. 8(a) to FIG. 8(d) may alternatively be suspended.

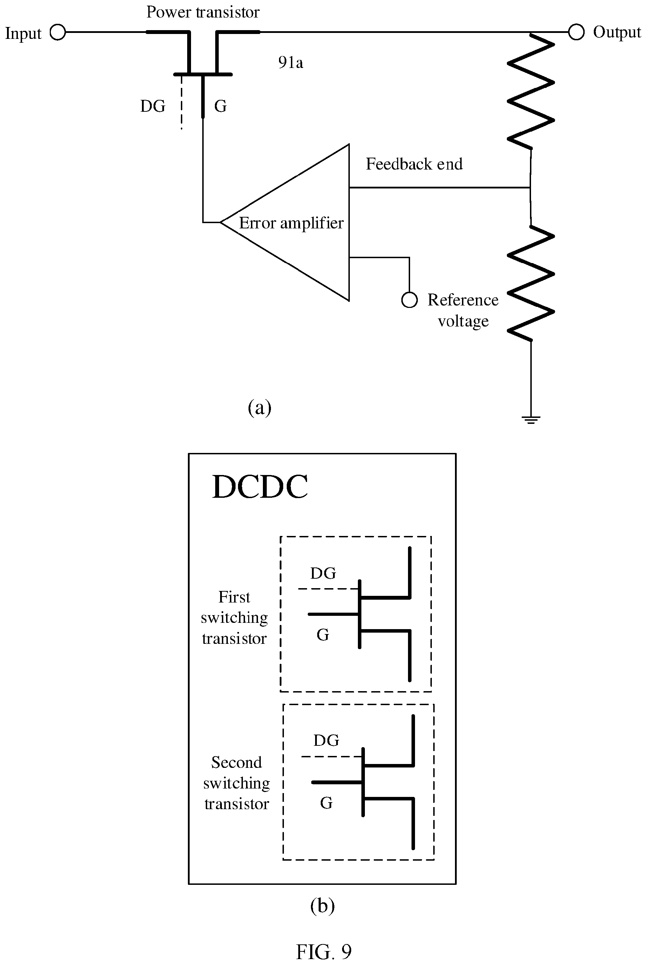

FIG. 9 is a schematic diagram of a power module of a FinFET using a redundant gate according to an embodiment of this application. Based on the foregoing embodiment, the power module is also an important circuit module for which heat dissipation needs to be considered in a chip design. Similar to a power amplifier, for the power module, a power transistor should be preferred to improve heat dissipation under a constraint of a chip area. The FinFET structure with the redundant gate described in the foregoing embodiment is used for the power transistor, so that heat dissipation performance of the power module may be improved, and area optimization may be achieved.

A low dropout regulator (LDO: low drop out regulator) shown in FIG. 9(a) is one of typical power modules. As shown in the figure, because a power transistor in the LDO carries a large output current and generates a large amount of heat, the power transistor 91a may use a FinFET transistor with a redundant gate, to improve heat efficiency of the LDO. The power transistor 91a is coupled between an input and an output of the LDO, and effective gate of 91a is coupled to an output end of an error amplifier. An input end of the error amplifier is a feedback end of an output voltage, and another end of the error amplifier is an input end of a reference voltage. A redundant gate of the power transistor 91a may be suspended, or may be connected to a redundant potential.

FIG. 9(b) shows a direct current to direct current converter (DCDC: Direct current to direct current converter). Power transistors in the DCDC are a first switching transistor and a second switching transistor that are shown in the figure. Because the two transistors in the DCDC carry a large output current and generate a large amount of heat, the two transistors may use a FinFET structure based on a redundant gate, to improve heat efficiency of the DCDC. Effective gates (G) of the first switching transistor and the second switching transistor are configured to receive control signals for turning on and off corresponding switches. Redundant gates of the first switching transistor and the second switching transistor may be suspended, or may be connected to a redundant potential.

Specifically, the DCDC may be a closed-loop architecture, for example, buck (buck), boost (boost), or buck-boost (buck-boost); or may be an open-loop architecture, for example, a charge pump (charge pump).

The chip in the foregoing embodiments of this application may be used for various terminals. The terminal may be a mobile phone (mobile phone), a tablet computer (tablet computer), a laptop computer (laptop computer), a wearable device (for example, a smartwatch, a smart band, a smart helmet, or smart glasses), and other devices with a wireless access capability, such as a smart car, a mobile wireless router, and various Internet of Things (Internet of Things, IOT) devices, including various smart home devices (for example, a smart meter and a smart appliance) and smart city devices (for example, a security protection or monitoring device and intelligent road traffic facilities).

In the embodiments of this application and the accompanying drawings, terms "first", "second", "third", and the like are used to distinguish similar objects, and are not necessarily used to describe a specific order or sequence. In addition, terms "include" and "have" and any variants thereof are intended to indicate non-exclusive inclusion, for example, including a series of steps or units. A method, a system, a product, or a device is not necessarily limited to those steps or units listed literally, but may include other steps or units not listed literally or inherent to the process, the method, the product, or the device.

It should be understood that in this application, "at least one" means one or more, and "a plurality of" means two or more. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" usually indicates an "or" relationship between associated objects. "At least one of the following items (pieces)" or a similar expression thereof indicates any combination of these items, including a single item (piece) or any combination of a plurality of items (pieces). For example, at least one of a, b, or c may indicate a, b, c, a and b, a and c, b and c, or a, b, and c, where a, b, and c may be singular or plural.

It should be understood that sequence numbers of the foregoing processes do not mean execution sequences in this application. The execution sequences of the processes should be determined based on functions and internal logic of the processes, and should not be constituted as any limitation on the implementation processes of embodiments of this application. The term "coupling" in this application is used to express interworking or interaction between different components, and may include a direct connection or an indirect connection by using another component.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated circuit, comprising:
a first metal oxide semiconductor field effect transistor (MOS transistor), wherein a first effective gate and a second effective gate are disposed in the first MOS transistor, and a first redundant gate is disposed between the first effective gate and the second effective gate;
the first effective gate, the second effective gate, and the first redundant gate cover a plurality of fins arranged in parallel;
the first effective gate and the second effective gate are connected to a gate terminal of the first MOS transistor;
fins on both sides of the first effective gate and fins on both sides of the second effective gate are respectively connected to a source terminal and a drain terminal of the first MOS transistor; and
the first redundant gate is connected to a redundant potential or suspended.

2. The integrated circuit according to claim 1, further comprising:
a second redundant gate, wherein the second redundant gate is located between the first gate and the second gate, and
the second redundant gate is connected to the redundant potential or suspended.

3. The integrated circuit according to any one of claims 1 and 2, wherein
the first MOS transistor is an N-type metal oxide semiconductor effect transistor (NMOS transistor), and the redundant potential is coupled to a ground terminal of the integrated circuit.

4. The integrated circuit according to claim 3, further comprising:
a first guard ring, wherein
the first guard ring is disposed on one or more sides of the NMOS transistor, and
the first guard ring is a P-type guard ring.

5. The integrated circuit according to any one of claims 1 and 2, wherein
the first MOS transistor is a P-type metal oxide semiconductor effect transistor (PMOS transistor), and the redundant potential terminal is coupled to a power supply terminal of the integrated circuit.

6. The integrated circuit according to claim 5, further comprising:
a first guard ring, wherein
the first guard ring is disposed on one or more sides of the PMOS transistor, and
the first guard ring is an N-type guard ring.

7. The integrated circuit according to claim 4 or 6, wherein
one or more openings are disposed on the first guard ring.

8. The integrated circuit according to any one of claims 1 and 7, wherein
the first MOS transistor is disposed in a hotspot area of the integrated circuit.

9. A power amplifier, comprising:
a first amplifier transistor, wherein
the first amplifier transistor is configured to amplify a signal received by the power amplifier, and
the first amplifier comprises the first MOS transistor according to any one of claims 1 to 8.

10. A power module, comprising:
a power transistor, wherein the power transistor comprises the first MOS transistor according to any one of claims 1 to 8.

11. A terminal, comprising the integrated circuit according to any one of claims 1 to 8, the power amplifier according to claim 9, or the power module according to claim 10.
